# EUROPÄISCHE PATENTSCHRIFT

(11) **EP 1 745 520 B1**
(45) Veröffentlichungstag und Bekanntmachung des Hinweises auf die Patenterteilung: **21.10.2015**
(21) Anmeldenummer: 05738451.3
(22) Anmeldetag: 10.05.2005
(51) Int. Cl.: H01L 51/40, H05B 33/10, C09D 11/00, H05B 33/14, C09K 11/02

(54) **LÖSUNGEN ORGANISCHER HALBLEITER**
SOLUTIONS OF ORGANIC SEMICONDUCTORS
SOLUTIONS DE SEMICONDUCTEURS ORGANIQUES

(30) Priorität: 11.05.2004 DE 102004023276
(43) Veröffentlichungstag der Anmeldung: 24.01.2007
(73) Patentinhaber: Merck Patent GmbH, 64293 Darmstadt (DE)
(72) Erfinder: STEIGER, Jürgen, 40237 Düsseldorf (DE); SPREITZER, Hubert, 68519 Viernheim (DE)
(86) Internationale Anmeldenummer: PCT/EP2005/005022
(87) Internationale Veröffentlichungsnummer: WO 2005/112145

(56) Entgegenhaltungen:
- EP-A- 0 610 929
- WO-A-02/069119
- WO-A-02/072714
- WO-A-03/019693
- US-A- 5 091 004
- US-A1- 2003 127 977
- US-A1- 2003 215 571
- PATENT ABSTRACTS OF JAPAN Bd. 016, Nr. 490 (C-0994), 12. Oktober 1992 (1992-10-12) & JP 04 180977 A (HITACHI CHEM CO LTD), 29. Juni 1992 (1992-06-29)
- HEBNER T R ET AL: "Ink-jet printing of doped polymers for organic light emitting devices" APPLIED PHYSICS LETTERS, AMERICAN INSTITUTE OF PHYSICS. NEW YORK, US, Bd. 72, Nr. 5, 2. Februar 1998 (1998-02-02), Seiten 519-521, XP012020626 ISSN: 0003-6951

## Beschreibung

Die vorliegende Erfindung betrifft Lösungen organischer Halbleiter, sowie deren Verwendung in der Elektronikindustrie

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. Die Entwicklung organischer Transistoren (O-TFTs, O-FETs), organischer integrierter Schaltungen (O-ICs) und organischen Solarzellen (O-SCs) ist im Forschungsstadium schon sehr weit gediehen, so dass eine Markteinführung innerhalb der nächsten Jahre erwartet werden kann. Bei den organischen Elektrolumineszenzvorrichtungen (OLEDs) ist die Markteinführung bereits erfolgt, wie beispielsweise die Autoradios der Firma Pioneer oder eine Digitalkamera der Firma Kodak mit "organischem Display" belegen. Auch bei den polymeren lichtemittierenden Dioden (PLEDs) ist ein erstes Produkt in Form einer kleinen Anzeige in einem Rasierapparat der Firma Philips N. V. am Markt erhältlich. Der allgemeine Aufbau solcher PLEDs ist in WO 90/13148 wiedergegeben. Trotz aller Fortschritte sind noch deutliche Verbesserungen nötig, um diese Displays zu einer echten Konkurrenz zu den derzeit marktbeherrschenden Flüssigkristallanzeigen (LCD) zu machen.

Um zu vollfarbigen Anzeigevorrichtungen zu kommen, ist es nötig, Beschichtungsverfahren zu entwickeln, die es erlauben, die drei Grundfarben (rot, grün, blau) räumlich getrennt aufzubringen. Da die Polymere im Allgemeinen aus Lösung aufgebracht werden, sind hierbei Druckverfahren eine Möglichkeit der Wahl. Derzeit wird wegen der guten Steuerbarkeit, der erreichbaren Auflösung und der großen Variabilität hauptsächlich an Tintenstrahl-Druckverfahren (ink-jet printing, IJP) gearbeitet. Grundsätzlich eignen sich aber auch andere Druckverfahren, wie z. B. Offsetdruck, Transferdruck oder Tiefdruckverfahren. Andererseits können auch entsprechende Farbdisplays durch photolithographische Verfahren erzeugt werden; hierbei können dann Flächenbeschichtungsverfahren verwendet werden, wie sie auch unten für einfarbige Anzeigen beschreiben werden. Für all diese Möglichkeiten benötigt man geeignete Polymerlösungen, die sich einerseits zum Drucken eignen, die andererseits aber auch die Eigenschaften der PLEDs nicht verschlechtern. Auch für einfarbige Anzeigevorrichtungen, die beispielsweise durch Spincoating erzeugt werden können, werden geeignete Polymerlösungen benötigt. Da allgemein bekannt ist, dass die Wahl der Lösemittel und auch die Löslichkeit der Polymere in diesem Lösemittel bzw. der Lösemittelmischung die Morphologie des gebildeten Films entscheidend beeinflusst, lässt sich hierüber auch das Elektrolumineszenzverhalten steuern.

In WO 02/069119 werden Lösungen organischer Halbleiter zur Verwendung in Tintenstrahldruckverfahren beschrieben, bei denen Lösemittelmischungen aus einem schlechten Lösemittel mit einem relativ hohen Siedepunkt und einem guten Lösemittel mit einem relativ niedrigen Siedepunkt verwendet werden. Durch das Verdampfen des flüchtigeren Lösemittels entsteht beim Trocknen schnell eine gesättigte Lösung des Materials, das in Folge ausfällt. Dadurch wird ein radialer Fluss des Materials zu den Rändern des Pixels verhindert und eine relativ gleichmäßige Materialverteilung ermöglicht. Diese Methode zeigt jedoch den entscheidenden Nachteil, dass das Material nicht gleichmaßig eintrocknet, sondern dass sich ein Niederschlag bildet, der zu deutlichen Inhomogenitäten des Films führt. In US 2003/0127977 wird beispielsweise durch SEM (scanning electron microscopy) gezeigt, dass ein Film schlechte Eigenschaften zeigt, wenn das Material beim Trocknen ausfällt. Dadurch ist keine gleichmäßige und homogene Elektrolumineszenz aus dem Pixel möglich. Durch die Unregelmäßigkeit des films ist weiterhin kein gleichmäßiger Stromfluss möglich. Es ist zu vermuten, dass sich dadurch bevorzugte Stromkanäle ausbilden, die letzten Endes zu Kurzschlüssen und somit deutlich geringerer Stabilität des Devices führen. Eigene erfahrungen, die diese Experimente nachgestellt haben, haben weiterhin gezeigt, dass diese inhomogenen Pixel zu einer Reduktion der Leuchteffizienz führen. So führen diese Lösungen möglicherweise zwar zu verbesserten Anwendungseigenschaften für den Tintenstrahldruck, aber wenn diese mit einer Verschlechterung der Elektrolumineszenzeigenschaften einhergehen, werden solche Lösungen nicht breit angewandt werden können.

In WO 02/072714 werden Lösungen in einem Gemisch aus zwei (oder auch drei) Lösemitteln vorgeschlagen, wobei beide Lösemittel einen Siedepunkt kleiner 200 °C, haben und ein Lösemittel einen Siedepunkt zwischen 140 °C und 200 °C hat, die weiterhin keine benzylischen CH₂- und CH-Gruppen enthalten und die bestimmte Einschränkungen für die Substituenten an aromatischen Lösemitteln aufweisen. Als besonders günstig wird beschrieben, wenn die Lösung schnell eindickt. Dies wird dadurch erreicht, dass binäre oder ternäre Lösemittelgemische verwendet werden, bei denen der organische Halbleiter in dem Lösemittel mit dem höchsten Siedepunkt die geringste Löslichkeit hat bzw. in diesem Lösemittel sehr dick oder gelartig ist. Dann findet beim Eindicken eine schnelle Viskositätssteigerung statt. Jedoch ist es nicht immer möglich, geeignete Lösemittelsysteme einer derartigen Zusammensetzung zu finden, in denen der organische Halbleiter schnell eindickt, ohne dabei auszufallen.

In EP 1134269 wird beschrieben, dass es besonders vorteilhaft ist, wenn Lösungen polymerer fluoreszierender Substanzen, die mindestens eine Arylen-Vinylen-Einheit aufweisen, einen Gehalt an schlechtem Lösemittel von nicht mehr als 10000 ppm, bevorzugt nicht mehr als 5000 ppm (bestimmt durch Gaschromatographie) aufweisen, wobei die untere Grenze nicht festgelegt ist. An anderer Stelle der Beschreibung wird als bevorzugte Obergrenze sogar ein Gehalt an schlechtem Lösemittel von nicht mehr als 1000 ppm angegeben, was ca. 0.1 Gew.% (bei vergleichbarer Dichte) entspricht. Als schlechte Lösemittel werden vor allem Alkohole, insbesondere Methanol, Ethanol und *iso*-Propanol, beschrieben. Als Vorteil dieser Lösungen wird eine höhere Leuchteffizienz angegeben, was in einem Beispiel (mit einem Poly-para-phenylenvinylen-Derivat) belegt wird.

Beim Nachstellen dieses Beispiels konnten wir diese Ergebnisse jedoch nicht reproduzieren. Im Gegenteil haben wir gefunden, dass insbesondere ein höherer Anteil eines schlechten Lösemittels in der Polymerlösung zu deutlich steileren Strom-Spannungs-Helligkeits-Kurven und zu höheren Leuchteffizienzen führt. Dies ist ein überraschendes Ergebnis, das im Widerspruch zu den oben genannten Beschreibungen steht. Solche Polymerlösungen sind daher Gegenstand der vorliegenden Erfindung.

Gegenstand der Erfindung sind einphasige, flüssige Zusammensetzungen (Lösungen), enthaltend
- mindestens einen organischen Halbleiter, der mindestens eine hochmolekulare Komponente enthält,
- und mindestens ein organisches Lösemittel A, das ein gutes Lösemittel für den organischen Halbleiter ist,
- und mindestens ein organisches Lösemittel B, das ein schlechtes Lösemittel für den organischen Halbleiter ist,
dadurch gekennzeichnet, dass für die Siedepunkte (Sdp.) der Lösemittel A und B gilt: Sdp.(A) > Sdp.(B).

Lösungen im Sinne dieses Anmeldungstextes sind flüssige, homogene Mischungen von Festsubstanzen in flüssigen Lösemitteln, in denen die Feststoffe molekulardispers gelöst vorliegen, d. h. die Mehrzahl der Feststoffmoleküle liegt tatsächlich gelöst und nicht in Form von Aggregaten bzw. Nano- oder Mikropartikel vor.

Unter einem organischen Lösemittel im Sinne dieser Erfindung sollen organische Stoffe verstanden werden, die andere Stoffe auf physikalischem Wege zur Lösung bringen können, ohne dass sich beim Lösungsvorgang der lösende oder der gelöste Stoff chemisch verändern.
Unter einem guten Lösemittel im Sinne dieser Erfindung soll ein organisches Lösemittel verstanden werden, in dem der organische Halbleiter bei einer Konzentration von mindestens 5 g/L bei Raumtemperatur und Normaldruck unter Bildung einer klaren, fließfähigen Lösung löslich ist.
Unter einem schlechten Lösemittel im Sinne dieser Erfindung soll ein organisches Lösemittel verstanden werden, in dem der organische Halbleiter bei der oben genannten Konzentration bei Raumtemperatur und Normaldruck keine klare Lösung ergibt, d. h. in dem er ausflockt oder ein Gel bildet. Bevorzugt ist die Löslichkeit des organischen Halbleiters bei Raumtemperatur und Normaldruck kleiner als 3 g/L, besonders bevorzugt kleiner als 1 g/L, insbesondere kleiner als 0.3 g/L.

Im Rahmen der vorliegenden Erfindung beträgt die Raumtemperatur 20 °C, und Normaldruck bedeutet 1013 mbar.

Ein weiterer Erfindungsgegenstand ist die Verwendung der erfindungsgemäßen Lösungen, um Schichten des organischen Halbleiters auf einem Substrat zu erzeugen.

Eine bevorzugte Ausführungsform ist dabei die Verwendung von Druckverfahren zur Herstellung der organischen Halbleiterschichten. Besonders bevorzugt ist dabei die Verwendung von Tintenstrahl-Druckverfahren (IJP).

Eine weitere bevorzugte Ausführungsform ist die Verwendung von Flächenbeschichtungsverfahren zur Herstellung der organischen Halbleiterschichten, insbesondere die Verwendung von Spincoating.

Nochmals ein weiterer Erfindungsgegenstand sind Schichten der organischen Halbleiter, hergestellt unter Verwendung der erfindungsgemäßen Lösungen.

Nochmals ein weiterer Gegenstand der Erfindung sind organische elektronische Vorrichtungen, wie beispielsweise organische Feld-Effekt-Transistoren (O-FET), organische Dünnfilmtransistoren (O-TFT), organische integrierte Schaltungen (O-IC), organische Solarzellen (O-SC) oder organische Laserdioden (O-Laser), insbesondere aber organische und polymere Leuchtdioden (OLED, PLED), enthaltend mindestens eine erfindungsgemäße Schicht.

Schichten der an sich bekannten organischen Halbleiter sind in der Literatur bereits beschrieben. Die aus den erfindungsgemäßen Lösungen hergestellten Schichten zeigen gegenüber den bislang beschriebenen verbesserte elektronische Eigenschaften (dies ist u. a. in den Beispielen 1 bis 4 belegt). Insbesondere erhält man mit den aus den erfindungsgemäßen Lösungen hergestellten Schichten steilere Strom-Spannungs-Helligkeits-Kurven und höhere Leuchteffizienzen.

Organische Halbleiter im Sinne dieser Anmeldung sind niedermolekulare, oligomere, dendritische, leicht bis stark verzweigte, sowie insbesondere polymere, organische oder metallorganische Verbindungen bzw. Mischungen von Verbindungen, die als Feststoff bzw. als Schicht halbleitende Eigenschaften aufweisen, d. h. bei denen die Energielücke zwischen Leitungs- und Valenzband zwischen 0.1 und 4 eV, bevorzugt zwischen 1.0 und 3.5 eV, liegt.

Als organischer Halbleiter wird hier entweder eine Reinkomponente, die dann nur eine hochmolekulare Komponente enthält, oder eine Mischung von zwei oder mehreren Komponenten, von denen mindestens eine halbleitende Eigenschaften aufweisen muss, verwendet. Bei der Verwendung von Mischungen ist es jedoch nicht notwendig, dass jede Komponente halbleitende Eigenschaften aufweist. So können beispielsweise inerte niedermolekulare Verbindungen zusammen mit halbleitenden Polymeren verwendet werden. Ebenso können nicht-leitende Polymere, die als inerte Matrix bzw. Binder dienen, zusammen mit einer oder mehreren niedermolekularen Verbindungen oder weiteren Polymeren, die halbleitende Eigenschaften aufweisen, verwendet werden.
Die hochmolekulare Komponente, die oligomer, dendritisch, leicht bis stark verzweigt, sowie insbesondere polymer sein kann, hat ein Molekulargewicht M_{w} von größer 3000 g/mol, bevorzugt von größer 10000 g/mol, besonders bevorzugt von größer 50000 g/mol.
Die potenziell beigemischte nicht-leitende Komponente ist im Sinne dieser Anmeldung als eine elektro-optisch nicht wirksame, inerte, passive Verbindung zu verstehen. Diese Komponente kann, wie bei Lackformulierungen üblich, als Binder bezeichnet werden.

Bevorzugt sind Lösungen polymerer organischer Halbleiter (welche eventuell weitere Substanzen eingemischt enthalten). Als polymere organische Halbleiter im Sinne der vorliegenden Beschreibung werden insbesondere
(i) die in EP 0443861, WO 94/20589, WO 98/27136, EP 1025183, WO 99/24526, DE 19953806 und EP 0964045 offenbarten, in organischen Lösemitteln löslichen, substituierten Poly-p-arylen-vinylene (PAVs),
(ii) die in EP 0842208, WO 00/22027, WO 00/22026, DE 19846767, WO 00/46321, WO 99/54385 und WO 00/55927 offenbarten, in organischen Lösemitteln löslichen, substituierten Polyfluorene (PFs),
(iii) die in EP 0707020, WO 96/17036, WO 97/2-0877, WO 97/31048, WO 97/39045 und WO 03/020790 offenbarten, in organischen Lösemitteln löslichen, substituierten. Poly-spirobifluorene (PSFs),
(iv) die in WO 92/18552, WO 95/07955, EP 0690086, EP 0699699 und WO 03/099901 offenbarten, in organischen Lösemitteln löslichen, substituierten Poly-paraphenylene (PPPs) oder - biphenylene,
(v) die in WO 05/014689 offenbarten, in organischen Lösemitteln löslichen, substituierten Poly-dihydrophenanthrene (PDHPs),
(vi) die in WO 04/041901 und WO 04/113412 offenbarten, in organischen Lösemitteln löslichen, substituierten Poly-trans-indenofluorene und Poly-cis-indenofluorene (PIF),
(vii) die in der nicht offen gelegten Anmeldung DE 102004020298.2 offenbarten, in organischen Lösemitteln löslichen, substituierten Poly-phenanthrene,
(viii) die in EP 1028136 und WO 95/05937 offenbarten, in organischen Lösemittel löslichen, substituierten Polythiophene (PTs),
(ix) die in T. Yamamoto et al., J. Am. Chem. Soc. 1994, 116, 4832 offenbarten, in organischen Lösemitteln löslichen Polypyridine (PPys),
(x) die in V. Gelling et al., Polym. Prepr. 2000, 41, 1770 offenbarten, in organischen Lösemitteln löslichen Polypyrrole,
(xi) substituierte, lösliche Copolymere, die Struktureinheiten aus zwei oder mehr der Klassen (i) bis (ix) aufweisen, wie zum Beispiel in WO 02/077060 beschrieben,
(xii) die in Proc. of ICSM '98, Part I & II**.** (in: Synth. Met. 1999, 101/102) offenbarten, in organischen Lösemitteln löslichen konjugierten Polymere,
(xiii) substituierte und unsubstituierte Poly-vinyl-carbazole (PVKs), wie beispielsweise in R. C. Penwell et al., J. Polym. Sci., Macromol. Rev. 1978, 13, 63-160 offenbart,
(xiv) substituierte und unsubstituierte Triarylaminpolymere, wie beispielsweise in JP 2000/072722 offenbart, und
(xv) lösliche Polymere, welche phosphoreszierende Einheiten enthalten, wie beispielsweise in EP 1245659, WO 03/001616, WO 03/018653, WO 03/022908, WO 03/080687, EP 1311138, WO 03/102109, WO 04/003105, WO 04/015025 und einigen der weiter oben bereits zitierten Schriften offenbart, verstanden.

Des Weiteren bevorzugt sind auch Lösungen von nicht-leitenden Polymeren (MatrixPolymere), welche niedermolekulare, oligomere, dendritische, leicht bis stark verzweigte, und/oder polymere organische und/oder metallorganische Halbleiter eingemischt enthalten.

Die erfindungsgemäßen Lösungen enthalten zwischen 0.01 und 20 Gew.%, bevorzugt zwischen 0.1 und 15 Gew.%, besonders bevorzugt zwischen 0.2 und 10 Gew.%, ganz besonders bevorzugt zwischen 0.25 und 5 Gew.% des organischen Halbleiters bzw. des entsprechenden Blends. Die Prozentangaben beziehen sich auf 100% für das gesamte Gemisch der Lösemittel.

Die Viskosität der erfindungsgemäßen Lösungen ist variabel. Allerdings verlangen gewisse Beschichtungstechniken eine Verwendung gewisser Viskositätsbereiche. So ist für die Beschichtung durch IJP ein Bereich von ca. 4 bis 25 mPa·s vorteilhaft. Für Flächenbeschichtungen (wie Spincoating) können Viskositäten im Bereich von ca. 5 bis 40 mPa*s vorteilhaft sein. Für andere Druckverfahren, z. B. Tiefdruckverfahren, kann aber auch eine deutlich höhere Viskosität, beispielsweise im Bereich von 20 bis 500 mPa·s, durchaus Vorteile ergeben. Die Einstellung der Viskosität kann durch die Wahl des geeigneten Molekulargewichtsbereiches des organischen Halbleiters bzw. Matrix-Polymers sowie durch Wahl eines geeigneten Konzentrationsbereichs und Wahl der Lösemittel erfolgen.

Die Oberflächenspannung der erfindungsgemäßen Lösungen ist zunächst nicht eingeschränkt. Durch die Verwendung entsprechender Lösemittelgemische und die Anwendung wird diese aber i. d. R. im Bereich von 20 bis 60 dyn/cm, bevorzugt im Bereich von 25 bis 50 dyn/cm, ganz besonders bevorzugt im Bereich von 25 bis 40 dyn/cm liegen.

Die erfindungsgemäßen Lösungen enthalten - wie oben beschrieben - mindestens zwei verschiedene organische Lösemittel A und B, von denen.das Lösemittel A ein gutes Lösemittel für den organischen Halbleiter ist und das Lösemittel B ein schlechtes Lösemittel für den organischen Halbleiter ist, und wobei außerdem für die Siedepunkte (Sdp.) der Lösemittel gilt: Sdp.(A) > Sdp (B).

Hierbei ist es bevorzugt, wenn der Siedepunkt des Lösemittels A größer als 80 °C ist, bevorzugt größer als 100 °C, besonders bevorzugt größer als 110 °C, für Tintenstrahldruck ganz besonders bevorzugt größer als 140 °C. Eine mit dieser Bevorzugung schon erreichte weitere technische Einschränkung ist der Verzicht auf einige giftige bzw. nachgewiesen cancerogene Lösemittel, was zum Beispiel auf Chloroform (Sdp. 61 °C), Tetrachlormethan (Sdp. 77 °C) und Benzol (Sdp. 80 °C) zutrifft. Diese Siedepunktgrenze ist technisch sinnvoll, da es sich erwiesen hat, dass bei Verwendung von guten Lösemitteln mit niedrigerem Siedepunkt beim Tintenstrahldrucken das Eintrocknen der Düsen innerhalb weniger Sekunden nach Beendigung des Druckvorgangs stattfindet. Sobald dieser Wert mindestens bei etwa 10 Sekunden liegt, kann durch geeignete technische Hilfsmittel (z. B. Druckkopf fährt in Warteposition, Düsen werden mit Kappe mechanisch verschlossen) ein Austrocknen verhindert werden. Auch für das Spincoating ist ein Lösemittel mit zu niedrigem Siedepunkt nicht bevorzugt, da dies zu morphologisch ungünstigeren Schichten führt.

Weiterhin bevorzugt ist der Siedepunkt des Lösemittels A kleiner als 300 °C, bevorzugt kleiner oder gleich 270 °C, besonders bevorzugt kleiner oder gleich 250 °C. Bei höher siedenden Lösemitteln ist das restliche Lösemittel nach Filmbildung nur schwierig und unter großem technischen Aufwand vollständig zu entfernen.

Als sinnvolle Untergrenze des Siedepunkts des Lösemittels B ist 50 °C anzugeben. Ein tieferer Siedepunkt macht eine reproduzierbare Herstellung der Lösungen bzw. der Schichten schwierig, da dann eine Lösungskomponente zu flüchtig ist. Weiterhin ist der Siedepunkt des Lösemittels B bevorzugt kleiner als 250 °C, besonders bevorzugt kleiner oder gleich 200 °C, ganz besonders bevorzugt kleiner oder gleich 150 °C.

Der Schmelzpunkt der Lösemittel A und B ist bevorzugt kleiner oder gleich 15 °C. Ein solcher Schmelzpunkt ist sinnvoll, da die Lösungen unter Umständen (zwischen Herstellung und Einsatz) über Tage bis zu Monaten gelagert, bzw. eventuell auch transportiert werden müssen. Hier muss sichergestellt werden, dass die Lösungen auch als solche stabil bleiben und nicht bei Lagerung, Transport und/oder kleineren Temperaturschwankungen ausfrieren oder sonstige nachteiligen Lager- und/oder Transportschäden erleiden.

Weiterhin ist es bevorzugt, wenn die Differenz der Siedepunkte zwischen dem Lösemittel A und dem Lösemittel B mehr als 5 K beträgt, bevorzugt mehr als 10 K, besonders bevorzugt mehr als 20 K, ganz besonders bevorzugt mehr als 30 K.

Das Verhältnis der Lösemittel A und B zueinander ist in weiten Bereichen variierbar. Um aber die besten Effekte zu erzielen, sollte das Lösemittel A zu einem Anteil von 50 bis 99.9 Vol.%, bevorzugt 70 bis 99.8 Vol.%, besonders bevorzugt 85 bis 99.5 Vol.%, ganz besonders bevorzugt 90 bis 99 Vol% verwendet werden. Entsprechend sollte das Lösemittel B zu einem Anteil von 0.1 bis 50 Vol.%, bevorzugt 0.2 bis 30 Vol.%, besonders bevorzugt 0.5 bis 15 Vol.%, ganz besonders bevorzugt 1 bis 10 Vol% verwendet werden. Die Gesamtprozentzahl der Anteile der jeweiligen Lösemittelmischung ergibt dabei immer 100 %.

Es kann auch sinnvoll sein, noch weitere gute und/oder schlechte Lösemittel zusätzlich zu den Lösemitteln A und B zu verwenden. So kann es durchaus sinnvoll und bevorzugt sein, jeweils zwei oder mehrere Lösemittels von Typ A und/oder Typ B zu verwenden, da dadurch teilweise die Optimierung bezüglich weiterer notwendiger Parameter (z. B. Anpassung der Oberflächenspannung, der Viskosität, etc.) einfacher erreicht werden kann, verglichen mit dem Fall, wo von jedem Typ nur exakt ein Lösemittel verwendet wird. Hier gilt dann wiederum für die Anteile der Lösemittel, dass die Anteile aller Lösemittel A bzw. aller Lösemittel B bevorzugt im Bereich liegen, wie oben beschrieben.

Des Weiteren kann es auch sinnvoll sein, neben dem organischen Halbleiter bzw. Blend noch weitere Additive, wie z. B. in WO 03/019693 beschrieben, zuzusetzen.

Die Verwendung beispielsweise Aldehyd-haltiger Lösemittel, nitrierter Aromaten und phosphorhaltiger Lösemittel (mangelnde Stabilität der Lösungen) und von Styrolderivaten bzw. anderen reaktiven Olefinen (Polymerisationsneigung der Lösemittel) hat sich als wenig vorteilhaft erwiesen. Ebenso haben sich Verbindungen, die zur Bildung von Peroxiden neigen, wie beispielsweise Diethylether oder Tetrahydrofuran, als wenig geeignet herausgestellt.

Als bevorzugte Lösemittel A, die sich als gute Lösemittel für eine große Bandbreite organischer Halbleiter oder auch inerter Matrixpolymere erwiesen haben, bieten sich einfach oder mehrfach substituierte aromatische Lösemittel, insbesondere substituierte Benzole, Naphthaline, Biphenyle und Pyridine, an. Bevorzugte Substituenten sind Alkylgruppen, die auch fluoriert sein können, Halogenatome, bevorzugt Chlor und Fluor, Cyanogruppen, Alkoxygruppen, Dialkylaminogruppen, bevorzugt solche mit nicht mehr als 4 C-Atomen, oder auch Estergruppierungen. Besonders bevorzugte Substituenten sind Fluor, Chlor, Cyano, Methoxy, Ethoxy, Methyl, Trifluormethyl, Methylcarboxylat und/oder Ethylcarboxylat, wobei auch mehrere unterschiedliche Substituenten vorhanden sein können. Aber auch nichtaromatische Lösemittel, wie beispielsweise Ameisensäurederivate, N-Alkyl-Pyrrolidone oder hochsiedende Ether, kommen als gute Lösemittel in Frage.

Besonders bevorzugt sind die in der nachfolgenden Tabelle 1 aufgeführten Lösemittel mit Siedepunkt zwischen 100 und 300 °C. Besonders geeignete Lösemittel müssen jedoch für jeden organischen Halbleiter separat bestimmt werden, so dass diese Tabelle nur einen generellen Anhaltspunkt geben kann.

**Tabelle 1: Besonders bevorzugte gute Lösemittel A**

| Lösemittel | CAS-Nummer | Siedepunkt [°C] | Schmelzpunkt [°C] |
|---|---|---|---|
| 3-Fluor-benzotrifluorid | 401-80-9 | 102 | -81 |
| Benzotrifluorid | 98-08-8 | 102 | -29 |
| Dioxan | 123-91-1 | 102 | 12 |
| Trifluormethoxybenzol | 456-55-3 | 102 | -50 |
| 4-Fluor-benzotrifluorid | 402-44-8 | 103 | -41 |
| 3-Fluorpyridin | 372-47-4 | 108 | n. a. |
| Toluol | 108-88-3 | 111 | -93 |
| 2-Fluortoluol | 95-52-3 | 113 | -62 |
| 2-Methylthiophen | 554-14-3 | 113 | -63 |
| 2-Fluor-benzotrifluorid | 392-85-8 | 115 | -51 |
| 3-Fluortoluol | 352-70-5 | 115 | -87 |
| Pyridin | 110-86-1 | 115 | -42 |
| 4-Fluortoluol | 352-32-9 | 116 | -56 |
| 2,5-Difluortoluol | 452-67-5 | 120 | -35 |
| 1-Chlor-2,4-difluorbenzol | 1435-44-5 | 127 | -26 |
| 2-Fluorpyridin | 372-48-5 | 127 | n. a. |
| 3-Chlorfluorbenzol | 625-98-9 | 127 | n. a. |
| 1-Chlor-2,5-difluorbenzol | 2367-91-1 | 128 | -25 |
| 4-Chlorfluorbenzol | 352-33-0 | 130 | -27 |
| Chlorbenzol | 108-90-7 | 132 | -45 |
| 2-Chlorfluorbenzol | 348-51-6 | 138 | -42 |
| p-Xylol | 106-42-3 | 138 | 12 |
| m-Xylol | 108-38-3 | 139 | -47 |
| o-Xylol | 95-47-6 | 144 | -24 |
| 2,6-Lutidin | 108-48-5 | 145 | -6 |
| 2-Fluor-m-xylol | 443-88-9 | 147 | n. a. |
| 3-Fluor-o-xylol | 443-82-3 | 150 | n. a. |
| 2-Chlorbenzotrifluorid | 88-16-4 | 152 | -7 |
| Dimethylformamid | 68-12-2 | 153 | -61 |
| 2-Chlor-6-fluortoluol | 443-83-4 | 154 | -27 |
| 2-Fluoranisol | 321-28-8 | 154 | -39 |
| Anisol | 100-66-3 | 154 | -37 |
| 2,3-Dimethylpyrazin | 5910-89-4 | 156 | n. a. |
| Brombenzol | 106-86-1 | 156 | -31 |
| 4-Fluoranisol | 459-60-9 | 157 | -45 |
| 3-Fluoranisol | 456-49-5 | 160 | -35 |
| 3-Trifluormethylanisol | 454-80-0 | 160 | -65 |
| 2-Methylanisol | 578-58-5 | 170 | -34 |
| Phenetol | 103-73-1 | 170 | -30 |
| 1,3-Benzodioxol | 274-09-9 | 173 | -18 |
| 4-Methylanisol | 104-93-8 | 174 | -32 |
| 3-Methylanisol | 100-84-5 | 175 | -55 |
| 4-Fluor-3-methylanisol | 2338-54-7 | 175 | n. a. |
| 1,2-Dichlorbenzol | 95-50-1 | 180 | -17 |
| 2-Fluorbenzonitril | 394-47-8 | -180 | n. a. |
| 4-Fluorveratrol | 398-62-9 | -180 | n. a. |
| 2,6-Dimethylanisol | 1004-66-6 | 182 | n. a. |
| Anilin | 62-53-3 | 184 | -6 |
| 3-Fluorbenzonitril | 403-54-3 | 185 | -16 |
| 2,5-Dimethylanisol | 1706-11-2 | 190 | -5 |
| 2,4-Dimethylanisol | 6738-23-4 | 191 | n. a. |
| Benzonitril | 100-47-0 | 191 | -13 |
| 3,5-Dimethylanisol | 874-63-5 | 193 | n. a. |
| N,N-Dimethylanilin | 121-69-7 | 194 | 2 |
| 1-Fluor-3,5-di-methoxybenzoyl | 52189-63-6 | ∼195 | n. a. |
| Phenylacetat | 122-79-2 | 196 | -30 |
| N-Methylanilin | 100-61-8 | 196 | -57 |
| Methylbenzoat | 93-58-3 | 198 | -12 |
| N-Methylpyrrolidon | 872-50-4 | 199 | -24 |
| 3,4-Dimethylanisol | 4685-47-6 | 200 | n. a. |
| o-Tolunitril | 529-19-1 | 205 | -13 |
| Veratrol | 91-16-7 | 207 | 15. |
| Ethylbenzoat | 93-89-0 | 212 | -34 |
| N,N-Diethylanilin | 91-66-7 | 217 | -38 |
| Propylbenzoat | 2315-68-6 | 231 | -51 |
| 1-Methylnaphthalin | 90-12-0 | 243. | -22 |
| Butylbenzoat | 136-60-7 | 250 | -22 |
| 2-Methylbiphenyl | 643-58-3 | 255 | n. a. |
| 2-Phenyl-pyridin | 1008-89-5 | ∼270 | n. a. |
| 2,2'-Bitolyl | 605-39-0 | ∼300 | n. a. |

Die in der Tabelle 1 aufgeführten Lösemittel können keinen Anspruch auf Vollständigkeit erheben. Die Bereitung einer erfindungsgemäßen Lösung ist dem Fachmann ohne Weiteres auch mit anderen hier nicht explizit aufgeführten Lösemitteln ohne erfinderisches Zutun möglich.

Bevorzugt sind also erfindungsgemäße Lösungen, enthaltend als Lösemittel A ein oder mehrere Lösemittel ausgewählt aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methyl-anisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, 3,4-Dimethylanisol, o-Tolunitril, Veratrol, Methylbenzoat, N,N-Diethylanilin, Propylbenzoat, 1-Methylnaphthalin, Butylbenzoat, 2-Methylbiphenyl, 2-Phenylpyridin oder 2,2'-Bitolyl.

Als bevorzugte Lösemittel B, die sich als schlechte Lösemittel für eine große Bandbreite organischer oder metallorganischer, oligomerer, verzweigter oder unverzweigter, polymerer oder dendritischer Halbleiter oder auch inerter Matrixpolymere erwiesen haben, bieten sich geradkettige, verzweigte oder cyclische Alkane, bevorzugt mit mehr als fünf C-Atomen, an. Hier können auch entsprechende technische Destillationsschnitte gewählt werden. Es kommen auch Terpene, (cyclo)aliphatische Alkohole, Ether, Ketone, Carbonsäureester oder einfach oder mehrfach substituierte aromatische Lösemittel, insbesondere substituierte Benzole, Naphthaline und Pyridine, die mit sehr langen Alkyl- oder Alkoxysubstituenten substituiert sind, in Frage.

Besonders bevorzugt sind die in der nachfolgenden Tabelle 2 aufgeführten Lösemittel B mit Siedepunkt zwischen 50 und 250 °C, wobei auch hier wiederum gilt, dass die besonders geeigneten Lösemittel für jeden organischen Halbleiter separat bestimmt werden müssen, so dass auch hier diese Tabelle nur als generelle Anhaltspunkt verstanden werden kann.

**Tabelle 2: Besonders bevorzugte schlechte Lösemittel B**

| Lösemittel | CAS-Nummer | Siedepunkt [°C] | Schmelzpunkt [°C] |
|---|---|---|---|
| *tert*-Butylmethylether | 1634-04-4 | 55 | -109 |
| Aceton | 67-64-1 | 57 | -95 |
| Methanol | 67-56-1 | 65 | -98 |
| Hexan | 110-54-3 | 69 | -96 |
| Ethylacetat | 141-78-6 | 77 | -84 |
| Ethanol | 64-17-5 | 78 | -130 |
| 2-Butanon | 78-93-3 | 80 | -87 |
| Cyclohexan | 110-82-7 | 81 | 7 |
| 2-Propanol | 67-63-0 | 82 | -89 |
| *tert*-Butanol | 75-65-0 | 82 | 26 |
| 1-Propanol | 71-23-8 | 97 | -127 |
| 2-Butanol | 78-92-2 | 98 | -115 |
| Heptan | 142-82-5 | 98 | -91 |
| 2-Pentanon | 107-87-9 | 100-110 | -78 |
| Methylcyclohexan | 108-87-2 | 101 | -127 |
| 3-Pentanon | 96-22-0 | 102 | -40 |
| 3-Pentanol | 584-02-1 | 116 | -8 |
| 1-Butanol | 71-36-3 | 118 | -89 |
| cis/trans-1,4-Dimethylcyclohexan | 589-90-2 | 120 | -87 |
| cis/trans-1,3-Dimethylcyclohexan | 591-21-9 | 121-124 | n. a. |
| Ethylenglycolmonomethylether | 109-86-4 | 124 | -85 |
| cis/trans-1,2-Dimethylcyclohexan | 583-57-3 | 124 | n. a. |
| Octan | 111-65-9 | 126 | -57 |
| Cyclopentanon | 120-92-3 | 130-131 | -51 |
| 2-Hexanol | 626-93-7 | 136 | n. a. |
| 1-Pentanol | 71-41-0 | 138 | -79 |
| 1,2,4-Trimethylcyclohexan | 2234-75-5 | 142 | n. a. |
| 4-Heptanon | 123-19-3 | 145 | -33 |
| 3-Heptanon | 106-35-4 | 148 | -39 |
| 2-Heptanon | 110-43-0 | 150 | -35 |
| Nonan | 111-84-2 | 151 | -51 |
| 3-Heptanol | 589-82-2 | 156 | -70 |
| 1-Hexanol | 111-27-3 | 157 | -52 |
| 2-Heptanol | 543-49-7 | 161 | n. a. |
| Diglyme | 111-96-6 | 162 | -64 |
| Buttersäurebutylester | 109-21-7 | 165 | n. a. |
| *tert*-Butylbenzol | 98-06-6 | 169 | -58 |
| Decan | 124-18-5 | 174 | -30 |
| 1-Heptanol | 111-70-6 | 176 | -36 |
| 2-Octanol | 123-96-6 | 179 | -39 |
| Butylcyclohexan | 1678-93-9 | 180 | -78 |
| 2-Ethyl-1-hexanol | 104-76-7 | 185 | -76 |
| Decalin | 91-17-8 | 187 | -31 |
| Propylenglycol | 57-55-6 | 187 | -60 |

| Lösemittel | CAS-Nummer | Siedepunkt [°C] | Schmelzpunkt [°C, |
|---|---|---|---|
| Dimethylsulfoxid | 867-68-5 | 189 | 19 |
| Glycol | 107-21-1 | 198 | -13 |
| 3,7-Dimethyl-1-octanol | 106-21-8 | ca. 200 | n. a. |
| 3,7-Dimethyl-3-octanol | 78-69-3 | ca. 200 | n. a. |
| Bernsteinsäuredimethylester | 106-65-0 | 200 | 18 |
| Benzyl-alkohol | 100-51-6 | 205 | -15 |
| DBE (technisches Gemisch aus Bernsteinsäure- und Glutarsäure-dimethylester) | "106-65-0" | 196-215 | n. a. |
| Dodecan | 112-40-3 | 215 | -12 |
| Bernsteinsäurediethylester | 123-25-1 | 218 | -20 |
| Triglyme | 112-49-2 | 220 | -40 |
| Adipinsäuredimethylester | 627-93-0 | 230 | 8 |
| 1-Decanol | 112-30-1 | 233 | n. a. |
| Bicyclohexyl | 92-51-3 | 239 | 3 |
| 2-Pyrrolidon | 616-45-5 | 245 | 25 |

Die in Tabelle 2 aufgeführten Lösemittel können keinen Anspruch auf Vollständigkeit erheben. Die Bereitung einer erfindungsgemäßen Lösung ist dem Fachmann ohne Weiteres auch mit anderen hier nicht explizit aufgeführten Lösemitteln ohne erfinderisches Zutun möglich.

Bevorzugt sind also erfindungsgemäße Lösungen, enthaltend als Lösemittel B mindestens ein Lösemittel ausgewählt aus *tert*-Butylmethylether, Aceton, Methanol, Hexan, Ethylacetat, Ethanol, 2-Butanon, Cyclohexan, 2-Propanol, *tert*-Butanol, 1-Propanol, 2-Butanol, Heptan, 2-Pentanon, Methylcyclohexan, 3-Pentanon, 3-Pentanol, 1-Butanol, 1,4-Dimethylcyclohexan, 1,3-Dimethylcyclohexan, Ethylenglycolmonomethylether, 1,2-Dimethylcyclohexan, Octan, Cyclopentanon, 2-Hexanol, 1-Pentanol, 1,2,4-Trimethylcyclohexan, 4-Heptanon, 3-Heptanon, 2-Heptanon, Nonan, 3-Heptanol, 1-Hexanol, -2-Heptanol, Diglyme, Buttersäurebutylester, *tert*-Butylbenzol, Decan, 1-Heptanol, 2-Octanol, Butylcyclohexan, 2-Ethyl-1-hexanol, Decalin, Propylenglycol, Dimethylsulfoxid, Glycol, 3,7-Dimethyl-1-octanol, 3,7-Dimethyl-3-octanol, Bernsteinsäuredimethylester, Benzyl-alkohol, DBE, Dodecan, Bernsteinsäurediethylester, Triglyme, Adipinsäuredimethylester, 1-Decanol, Bicyclohexyl oder 2-Pyrrolidon.

Um die Erfindung näher zu erläutern, sind in Tabelle 3 einige gut verwendbare erfindungsgemäße Lösemittelgemische zusammengestellt. Dies stellt nur einen Anhaltspunkt dar.

**Tabelle 3: Beispiele für erfindungsgemäße Lösemittelmischungen**

| Lösemittel A | Lösemittel B |
|---|---|
| Toluol | Methanol |
| Toluol | Ethanol |
| o-Xylol | Methanol |
| o-Xylol | Ethanol |
| o-Xylol | 2-Propanol |
| o-Xylol | Hexan |
| Anisol | Methanol |
| Anisol | Ethanol |
| Anisol | Methanol / Hexan |
| Methylanisol | Ethanol |
| Anisol / o-Xylol | Methanol |
| Anisol / o-Xylol | Ethanol |
| Anisol / o-Xylol | Methanol / Ethanol |

Zum Herstellen der Lösungen wird der organische Halbleiter bzw. Blend in der gewünschten Konzentration in dem gewünschen Lösemittelgemisch gelöst. Es kann auch sinnvoll sein, den organischen Halbleiter bzw. Blend erst in einem Teil der Lösemittel, beispielsweise in dem Lösemittel A, zu lösen und zu dieser Lösung dann das/die restlichen Lösemittel, beispielsweise das Lösemittel B, zuzugeben. Da organische Halbleiter bzw. deren Lösungen teilweise gegenüber Sauerstoff bzw. anderen Luftbestandteilen nicht stabil sind, kann es sinnvoll sein, diesen Vorgang unter einer inerten Atmosphäre, beispielsweise unter Stickstoff oder Argon, durchzuführen. Weiterhin kann es sinnvoll sein, den Lösevorgang beispielsweise durch Erhitzen und/oder Rühren zu beschleunigen. Aggregate des organischen Halbleiters bzw. des Matrixpolymers können dabei auch beispielsweise durch äußere mechanische Einwirkung, zum Beispiel durch Ultraschall, wie beschrieben in WO 03/019694, zerkleinert werden. Ebenso kann sich der Zusatz weiterer Additive, wie beispielsweise beschrieben in WO 03/019693, für die Anwendung als sinnvoll erweisen. Es hat sich weiterhin als sinnvoll erwiesen, vor Anwendung der Lösungen diese zu filtrieren, um sie von beispielsweise kleineren Mengen vernetzter Bestandteile und/oder von Staubpartikeln zu reinigen.

Es wurde gefunden, dass Elektrolumineszenzvorrichtungen, die aus erfindungsgemäßen Lösungen hergestellt wurden, in der Elektrolumineszenz bessere Ergebnisse zeigen, insbesondere steilere Strom-Spannungs-Helligkeits-Kurven und höhere Effizienz. Dies ist ein überraschendes und unerwartetes Ergebnis, das den Ergebnissen in der Literatur widerspricht. Solche Lösungen sind also besser geeignet als Lösungen gemäß dem Stand der Technik, um effiziente Elektrolumineszenzvorrichtungen herzustellen. Außerdem zeigen Polymere und Blendmaterialien in Filmen oder Pixeln, die aus erfindungsgemäßen Lösungen erzeugt wurden, keinerlei Inhomogenitäten in der Elektrolumineszenz.
Beim Eintrocknen der erfindungsgemäßen Lösungen fällt der organische Halbleiter nicht aus der Lösung aus. Dies führt zu deutlich homogeneren Filmen, als dies mit binären oder ternären Lösemittelsystemen der Fall ist, bei denen der organische Halbleiter bzw. andere Blendbestandteile im höchstsiedenden Lösemittel die geringste Löslichkeit aufweist.

Im vorliegenden Anmeldetext und auch in den im Weiteren folgenden Beispielen wird vor allem auf erfindungsgemäße Lösungen zur Herstellung polymerer Leuchtdioden und die entsprechenden Displays abgezielt. Trotz dieser Beschränkung der Beschreibung ist es für den Fachmann ohne weiteres erfinderisches Zutun möglich, entsprechende erfindungsgemäße Lösungen auch für die Herstellung anderer Devices (Vorrichtungen) anzuwenden, z. B. für organische Feld-Effekt-Transistoren (O-FETs), organische Dünnfilmtransistoren (O-TFTs), organische integrierte Schaltungen (O-ICs), organische Solarzellen (O-SCs) oder auch organische Laserdioden (O-Laser), um nur einige Anwendungen zu nennen.

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße Lösungen bereiten und diese anwenden, um daraus Schichten zu erzeugen.

### Beispiele

### Beispiel 1: Lösungen des Polymers POLY1 in Mischungen von Toluol (Lösemittel A) und Methanol (Lösemittel B):

### 1.1 Eingesetzte Materialien:

- Polymer POLY1 ist ein PPV-Polymer, welches durch eine Polymerisation der Monomere (Nummerierung wie in den Beispielen in WO 99/24526; Durchführung der Polymerisation analog den dort beschriebenen Beispielen) Z5, E3, E5 und Z1 im Verhältnis 49% zu 35% zu 15% zu 1% erhalten wurde. Der hier verwendete Ansatz POLY1-B64 hat ein M_{w} von 1200 kg/mol, ein Mₙ von 370 kg/mol und ein Mₚ von 910 kg/mol. Eine Lösung mit 5 g/L in Toluol weist eine Viskosität (bei 40 s⁻¹) von ca. 9.9 mPas und (bei 500 s⁻¹) von ca. 9.1 mPas auf.
- Lösemittel:
   - Toluol; Siedepunkt 111 °C; Löslichkeit POLY1-B64 > 20 g/L.
   - Methanol: Siedepunkt 65 °C; Löslichkeit POLY1-B64 < 0.05 g/L.

### 1.2 Untersuchung bzgl. der Anwendung in der EL (Elektrolumineszenz):

Es wurden 4 verschiedene Lösungen bereitet. Diese enthielten alle 5 g/L von POLY1-B64. Die Lösungen hatten folgende Lösemittelzusammensetzung:
- Lösung 1: 100% Toluol
- Lösung 2: 99.8% Toluol; 0.2% Methanol (0.15%)
- Lösung 3: 99.4% Toluol; 0.6% Methanol (0.45%)
- Lösung 4: 98.0% Toluol; 2.0% Methanol (1.71%)
(In Klammern ist die durch H-NMR bestimmte Lösemittelzusammensetzung angegeben; d. h. die tatsächlichen Methanolgehalte sind etwas niedriger als bei der Einwaage, vermutlich durch bevorzugtes Verdunsten beim N₂-Sättigen der Lösung).

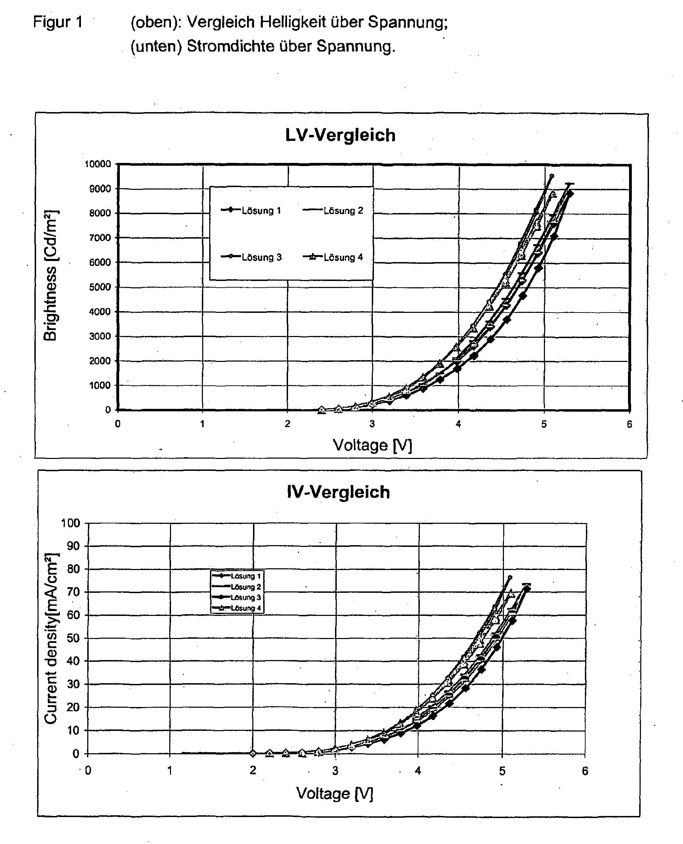

Mit den Lösungen wurden nun PLEDs (Polymere Leuchtdioden) präpariert. Die PLEDs wurden jeweils via Spincoating (Lackschleudern) hergestellt (ein allgemeines Verfahren dazu ist beispielsweise in der o. g. WO 02/072714 ausgeführt). Die PLEDs hatten folgenden Aufbau: ITO / PEDOT (20 nm) / LEP (80 nm) / Ba (5 nm), Ag (200 nm).
(ITO = Indium Zinn Oxid; PEDOT = Polythiophen-Derivat, als Dispersion von der Fa. H. C. Starck erhältlich; LEP = Lichtemittierendes Polymer).
Alle Lösungen ergaben optisch homogene Schichten ohne irgendwelche Mängel. Die PLEDs emittierten gelbes Licht (CIE-1931: X ∼ 0.51, Y ∼ 0.48).
Die EL-Evaluierung ist in Tabelle 4 gegenübergestellt und in der Figur 1 verdeutlicht.

**Tabelle 4 Effizienzen und benötigte Spannungen bei bestimmten Helligkeiten.**

| | @ Maximum | @ 100 Cd/m² | @ 800 Cd/m² | @ 5000 Cd/m² |
|---|---|---|---|---|
| | Eff. [Cd/A] | Eff. [Cd/A] | Eff. [Cd/A] | Eff. [Cd/A] |
| | U [V] | U [V] | U [V] | U [V] |
| Lösung 1 | | 11.98 | 13.71 | 12.37 |
| | 3.64 | 2.80 | 3.59 | 4.95 |
| Lösung 2 | 14.11 | 12.17 | 14.08 | 12.85 |
| | 3.64 | 2.77 | 3.53 | 4.92 |
| Lösung 3 | 14.66 | 12.55 | 14.63 | 13.46 |
| | 3.44 | 2.72 | 3.39 | 4.52 |
| Lösung 4 | 14.58 | 12.51 | 14.60 | 13.44 |
| | 3.50 | 2.69 | 3.34 | 4.47 |

Die erzeugten PLEDs wurden auch hinsichtlich operativer Lebensdauer untersucht. Dabei ergaben die PLEDs jeweils bei gleichen Stromdichten gleiche Lebensdauern (im Rahmen der Messgenauigkeit).

Die Ergebnisse aus Beispiel 1 zeigen das Folgende:
- Ein Methanolgehalt im gezeigten Bereich von 0.2 bis 2 % erhöht die Steilheit der Stromspannungskurven (d. h. höhere Ströme bei gleichen Spannungen) und auch geringfügig die Effizienz der jeweiligen PLED.
- Dieser Vorteil wird nicht durch etwaige Nachteile (z. B. operative Lebensdauer) erkauft. Dies ist für die Anwendung wichtig.
- Gerade wegen der in der o. g. EP 1134269 zitierten Ergebnisse sind die hier gezeigten Resultate völlig überraschend.

### Beispiel 2: Lösungen des Polymers POLY1 in Mischungen von Anisol (Lösemittel A) und 1-Butanol (Lösemittel B):

### 2.1 Eingesetzte Materialien:

- Polymer POLY1: wie in Beispiel 1 beschrieben.
- Lösemittel:
   - Anisol; Siedepunkt 154 °C; Löslichkeit POLY1-B64 > 20 g/L.
   - 1-Butanol: Siedepunkt 118 °C; Löslichkeit POLY1-B64 < 0.05 g/L.

### 2.2 Untersuchung bzgl. der Anwendung in der EL:

Es wurden 4 verschiedene Lösungen bereitet. Diese enthielten alle 5 g/L von POLY1-B64. Die Lösungen hatten folgende Lösemittelzusammensetzung:
- Lösung 5: 100% Anisol
- Lösung 6: 99.5% Anisol; 0.5% 1-Butanol (0.50%)
- Lösung 7: 98.0% Anisol; 2.0% 1-Butanol (1.97%)
- Lösung 8: 90% Anisol; 10% 1-Butanol (9.84%)
(In Klammern ist die durch H-NMR bestimmte Lösemittelzusammensetzung angegeben; in diesem Fall stimmt der 1-Butanolgehalt sehr gut mit der Einwaage überein).

Mit den Lösungen wurden analog zu den Angaben in Beispiel 1 PLEDs präpariert. Die EL-Evaluierung ist in Tabelle 5 gegenübergestellt.

**Tabelle 5 Effizienzen und benötigte Spannungen bei bestimmten Helligkeiten.**

| | @ Maximum | @ 100 Cd/m² | @ 800 Cd/m² | @ 5000 Cd/m² |
|---|---|---|---|---|
| | Eff. [Cd/A] | Eff. [Cd/A] | Eff. [Cd/A] | Eff. [Cd/A] |
| | U [V] | U [V] | U [V] | U [V] |
| Lösung 5 | 13.79 | 10.43 | 13.34 | 12.67 |
| | 3.84 | 2.84 | 3.74 | 5.31 |
| Lösung 6 | 14.39 | 12.31 | 14.36 | 13.13 |
| | 3.64 | 2.76 | 3.53 | 4.96 |
| Lösung 7 | 14.56 | 12.32 | 14.51 | 13.41 |
| | 3.66 | 2.74 | 3.49 | 4.97 |
| Lösung 8 | 13.56 | 9.42 | 13.45 | 12.75 |
| | 4.18 | 2.78 | 3.53 | 4.90 |

Die Ergebnisse aus Beispiel 2 zeigen das Folgende:
- Analog zu den Resultaten in Beispiel 1 führt auch hier eine Beimischung von Butanol zu steileren IV- (und LV-) Kurven. Aus den Ergebnissen der Lösung 8 könnte man zunächst schließen, daß der gewünschte Effekt bei 10% Butanol schon überkompensiert wurde. Bei hohen Leuchtdichten (vgl. die 5000 Cd/m²-Werte) trat wiederum der erfindungsgemäße Effekt auf.

### Beispiel 3: Lösungen des Polymers POLY1 in Mischungen von Toluol (Lösemittel A) und Cyclohexan bzw. n-Heptan bzw. ^{t}Butyl-methyl-ether (Lösemittel B):

### 3.1 Eingesetzte Materialien:

- Polymer POLY1: wie in Beispiel 1 beschrieben.
- Lösemittel:
   - Toluol; Siedepunkt 111 °C; Löslichkeit POLY1-B64 > 20 g/L.
   - Cyclohexan: Siedepunkt 81 °C; Löslichkeit POLY1-B64 < 0.05 g/L.
   - n-Heptan: Siedepunkt 98 °C; Löslichkeit POLY1-B64 < 0.05 g/L.
   - ^{t}Butyl-methyl-ether: Siedepunkt 55 °C; Löslichkeit POLY1-B64 < 0.05 g/L.

### 3.2 Untersuchung bzgl. der Anwendung in der EL:

Es wurden 4 verschiedene Lösungen bereitet. Diese enthielten alle 5 g/L von POLY1-B64. Die Lösungen hatten folgende Lösemittelzusammensetzung:
- Lösung 9: 100% Toluol
- Lösung 10: 98.0% Toluol; 2.0% Cyclohexan (1.79%)
- Lösung 11: 98.0% Toluol; 2.0% n-Heptan (1.92%)
- Lösung 12: 98.0% Toluol; 2.0% ^{t}Butyl-Methyl-ether (1.64%)
(In Klammern ist die durch H-NMR bestimmte Lösemittelzusammensetzung angegeben).

Mit den Lösungen wurden analog zu den Angaben in Beispiel 1 PLEDs präpariert. Allerdings wurde in diesem Fall ein 80 nm dicker PEDOT Film verwendet (Beispiele 1 und 2: jeweils 20 nm; s. o.).
Die EL-Evaluierung ist in Tabelle 6 gegenübergestellt.

**Tabelle 6 Effizienzen und benötigte Spannungen bei bestimmten Helligkeiten.**

| | @ Maximum | @ 100 Cd/m² | @ 800 Cd/m² | @ 5000 Cd/m² |
|---|---|---|---|---|
| | Eff. [Cd/A] | Eff. [Cd/A] | Eff. [Cd/A] | Eff. [Cd/A] |
| | U [V] | U [V] | U [V] | U [V] |
| Lösung 9 | 12.13 | 10.42 | 12.11 | 10.85 |
| | 3.79 | 2.87 | 3.71 | 5.14 |
| Lösung 10 | 12.66 | 10.74 | 12.63 | 11.58 |
| | 3.78 | 2.88 | 3.73 | 5.13 |
| Lösung 11 | 13.00 | 11.17 | 12.98 | 11.86 |
| | 3.81 | 2.93 | 3.88 | 5.51 |
| Lösung 12 | 12.00 | 10.35 | 11.99 | 10.91 |
| | 3.80 | 2.90 | 3.82 | 5.25 |

Die Ergebnisse aus Beispiel 3 zeigen das Folgende:
- Im Gegensatz zu den Resultaten, welche in den Beispielen 1 und 2 aufgeführt wurden, sind bei diesen Lösungen keine Steigerungen der Steilheit der IV-Kennlinien zu erkennen. Allerdings wird auch hier i. d. R. die Effizienz verbessert. Auch dieses Ergebnis ist überraschend.

### Beispiel 4: Lösungen des Polymers POLY2 in Mischungen von Toluol (Lösemittel A) und Methanol (Lösemittel B):

### 4.1 Eingesetzte Materialien:

- Polymer POLY2 ist ein SPIRO-Polymer analog dem Beispiel P27 in WO 03/020790, welches durch die dort ebenfalls beschriebene SUZUKI-Polymerisation enthalten wurde. Der hier verwendete Ansatz POLY2-B10 hat ein M_{w} von 380k g/mol, ein Mₙ von 100k g/mol und ein Mₚ von 320k g/mol. Eine Lösung mit 14 g/L in Anisol/o-Xylol (1:1) weist eine Viskosität (bei 40 s⁻¹) von ca. 6.3 mPas und (bei 500 s⁻¹) von ca. 6.4 mPas auf.
- Lösemittel:
   - Toluol; Siedepunkt 111 °C; Löslichkeit POLY2-B10 > 35 g/L.
   - Methanol: Siedepunkt 65 °C; Löslichkeit POLY2-B10 < 0.05 g/L.

### 4.2 Untersuchung bzgl. der Anwendung in der EL:

Es wurden 4 verschiedene Lösungen bereitet. Diese enthielten alle 11 g/L von POLY2-B10. Die Lösungen hatten folgende Lösemittelzusammensetzung:
- Lösung 13: 100% Toluol
- Lösung 14: 99.8% Toluol; 0.2% Methanol (0.17%)
- Lösung 15: 99.4% Toluol; 0.6% Methanol (0.52%)
- Lösung 16: 98.0% Toluol; 2.0% Methanol (1.77%)
(In Klammern ist die durch H-NMR bestimmte Lösemittelzusammensetzung angegeben; d. h. die tatsächlichen Methanolgehalte sind etwas niedriger als bei der Einwaage, vermutlich durch bevorzugtes Verdunsten beim N₂-Sättigen der Lösung).

Mit den Lösungen wurden analog zu den Angaben in Beispiel 1 PLEDs präpariert (d. h. hier auch wieder mit 20 nm PEDOT).
Alle Lösungen ergaben optisch homogene Schichten ohne irgendwelche Mängel. Die PLEDs emittierten rotes Licht (CIE-1931: X ∼ 0.67, Y ∼ 0.33).
Die EL-Evaluierung ist in Tabelle 7 gegenübergestellt.

**Tabelle 7 Effizienzen und benötigte Spannungen bei bestimmten Helligkeiten.**

| | @ Maximum | @ 1.00 Cd/m² | @ 800 Cd/m² |
|---|---|---|---|
| | Eff. [Cd/A] | Eff. [Cd/A] | Eff. [Cd/A] |
| | U [V] | U [V] | U [V] |
| Lösung 13 | 2.04 | 1.88 | 1.59 |
| | 2.84 | 3.38 | 5.75 |
| Lösung 14 | 2.02 | 1.92 | 1.58 |
| | 2.93 | 3.47 | 5.60 |
| Lösung 15 | 2.01 | 1.94 | 1.62 |
| | 2.84 | 3.28 | 5.12 |
| Lösung 16 | 2.05 | 1.97 | 1.63 |
| | 2.76 | 3.23 | 5.10 |

Die Untersuchung der operativen Lebensdauer ergab auch in diesem Fall, dass die PLEDs aus allen 4 Lösungen im Rahmen der Messgenauigkeit analoge Werte aufwiesen.

Die Ergebnisse aus Beispiel 4 zeigen das Folgende:
- Analog zu Beispiel 1 ist hier für ein völlig anderes Polymer gezeigt, dass auch hier bei steigenden Methanolgehalten die Steilheit der LV (und damit auch IV) Kurven zunimmt. Die Effizienzen sind nahezu unverändert (im Rahmen der Messgenauigkeit).

## Patentansprüche

1. Einphasige, flüssige Zusammensetzungen oder Lösungen, enthaltend
• mindestens einen organischen Halbleiter, der mindestens eine hochmolekulare Komponente enthält,
• und mindestens ein organisches Lösemittel A, in dem der Halbleiter bei einer Konzentration von mindestens 5 g/L bei Raumtemperatur und Normaldruck unter Bildung einer klaren, fließfähigen Lösung löslich ist,
• und mindestens ein organisches Lösemittel B, in dem der Halbleiter bei einer Konzentration von 5 g/L bei Raumtemperatur und Normaldruck keine klare Lösung ergibt,
**dadurch gekennzeichnet, dass** für die Siedepunkte (Sdp.) der Lösemittel A und B gilt: Sdp.(A) > Sdp.(B).

2. Lösungen gemäß Anspruch 1, **dadurch gekennzeichnet, dass** der organische Halbleiter in dem reinen Lösemittel A bei einer Konzentration von mindestens 5 g/L bei Raumtemperatur löslich ist.

3. Lösungen gemäß Anspruch 1 und/oder 2, **dadurch gekennzeichnet, dass** die Löslichkeit des organischen Halbleiters in dem reinen Lösemittel B bei Raumtemperatur kleiner als 0.3 g/L ist.

4. Lösungen gemäß einem oder mehreren der Ansprüche 1 bis 3, **dadurch gekennzeichnet, dass** der organische Halbleiter als Reinkomponente eingesetzt wird.

5. Lösungen gemäß einem oder mehreren der Ansprüche 1 bis 3, **dadurch gekennzeichnet, dass** der organische Halbleiter eine Mischung aus zwei oder mehreren Komponenten ist, von denen mindestens eine halbleitende Eigenschaften aufweist.

6. Lösungen gemäß einem oder mehreren der Ansprüche 1 bis 5, **dadurch gekennzeichnet, dass** die hochmolekulare Komponente ein Molekulargewicht M_{w} von größer 50000 g/mol aufweist.

7. Lösungen gemäß einem oder mehreren der Ansprüche 1 bis 6, **dadurch gekennzeichnet, dass** der polymere organische Halbleiter ausgewählt ist aus den Klassen der in organischen Lösemitteln löslichen substituierten Poly-p-arylen-vinylene (PAVs), Polyfluorene (PFs), Poly-spirobifluorene (PSFs), Poly-paraphenylene (PPPs) oder -biphenylene, Poly-dihydrophenanthrene (PDHPs), trans- und cis-Poly-indenofluorene (PIF), Poly-phenanthrene, Polythiophene (PTs), Polypyridine (PPys), Polypyrrole, Copolymere, die Struktureinheiten aus zwei oder mehr dieser Klassen aufweisen, Poly-vinyl-carbazole (PVKs), Triarylaminpolymere und/oder Polymere mit phosphoreszierenden Einheiten.

8. Lösungen gemäß einem oder mehreren der Ansprüche 1 bis 7, **dadurch gekennzeichnet, dass** nicht-leitende Polymere (Matrix-Polymere), welche niedermolekulare, oligomere, dendritische, leicht bis stark verzweigte und/oder polymere organische und/oder metallorganische Halbleiter beigemischt enthalten, verwendet werden.

9. Lösungen gemäß einem oder mehreren der Ansprüche 1 bis 8, **dadurch gekennzeichnet, dass** sie zwischen 0.01 und 20 Gew.% des organischen Halbleiters enthalten.

10. Lösungen gemäß einem oder mehreren der Ansprüche 1 bis 9, **dadurch gekennzeichnet, dass** der Siedepunkt des Lösemittels A größer als 110 °C ist.

11. Lösungen gemäß einem oder mehreren der Ansprüche 1 bis 10, **dadurch gekennzeichnet, dass** der Siedepunkt des Lösemittels A kleiner als 300 °C ist.

12. Lösungen gemäß einem oder mehreren der Ansprüche 1 bis 11, **dadurch gekennzeichnet, dass** der Siedepunkt des Lösemittels B größer als 50 °C ist.

13. Lösungen gemäß einem oder mehreren der Ansprüche 1 bis 12, **dadurch gekennzeichnet, dass** der Siedepunkt des Lösemittels B kleiner als 250 °C ist.

14. Lösungen gemäß einem oder mehreren der Ansprüche 1 bis 13, **dadurch gekennzeichnet, dass** die Differenz der Siedepunkte zwischen dem Lösemittel A und dem Lösemittel B mehr als 10 K beträgt.

15. Lösungen gemäß einem oder mehreren der Ansprüche 1 bis 14, **dadurch gekennzeichnet, dass** das Lösemittel A zu einem Anteil von 70 bis 99.8 Vol% und das Lösemittel B zu einem Anteil von 0.2 bis 30 Vol.% verwendet werden.

16. Lösungen gemäß einem oder mehreren der Ansprüche 1 bis 15, **dadurch gekennzeichnet, dass** noch weitere gute und/oder schlechte Lösemittel zusätzlich zu den Lösemitteln A und B verwendet werden.

17. Lösungen gemäß einem oder mehreren der Ansprüche 1 bis 16, **dadurch gekennzeichnet, dass** als Lösemittel A einfach oder mehrfach substituierte aromatische Lösemittel, Ameisensäurederivate, N-Alkyl-Pyrrolidone oder hochsiedende Ether verwendet werden.

18. Lösungen gemäß Anspruch 17, **dadurch gekennzeichnet, dass** als Lösemittel A ein oder mehrere der Lösemittel ausgewählt sind aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methyl-anisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, 3,4-Dimethylanisol, o-Tolunitril, Veratrol, Ethylbenzoat, N,N-Diethylanilin, Propylbenzoat, 1-Methylnaphthalin, Butylbenzoat, 2-Methylbiphenyl, 2-Phenyl-pyridin oder 2,2'-Bitolyl.

19. Lösungen gemäß einem oder mehreren der Ansprüche 1 bis 18, **dadurch gekennzeichnet, dass** als Lösemittel B geradkettige, verzweigte oder cyclische Alkane, Terpene, (cyclo)aliphatische Alkohole, Ether, Ketone, Carbonsäureester oder einfach oder mehrfach substituierte aromatische Lösemittel, die mit sehr langen Alkyl- oder Alkoxysubstituenten substituiert sind, verwendet werden.

20. Lösungen gemäß Anspruch 19, **dadurch gekennzeichnet, dass** als Lösemittel B ein oder mehrere der Lösemittel ausgewählt sind aus tert-Butylmethylether, Aceton, Methanol, Hexan, Ethylacetat, Ethanol, 2-Butanon, Cyclohexan, 2-Propanol, tert-Butanol, 1-Propanol, 2-Butanol, Heptan, 2-Pentanon, Methylcyclohexan, 3-Pentanon, 3-Pentanol, 1-Butanol, 1,4-Dimethylcyclohexan, 1,3-Dimethylcyclohexan, Ethylenglycolmonomethylether, 1,2-Dimethylcyclohexan, Octan, Cyclopentanon, 2-Hexanol, 1-Pentanol, 1,2,4-Trimethylcyclohexan, 4-Heptanon, 3-Heptanon, 2-Heptanon, Nonan, 3-Heptanol, 1-Hexanol, 2-Heptanol, Diglyme, Buttersäurebutylester, tert-Butylbenzol, Decan, 1-Heptanol, 2-Octanol, Butylcyclohexan, 2-Ethyl-1-hexanol, Decalin, Propylenglycol, Dimethylsulfoxid, Glycol, 3,7-Dimethyl-1-octanol, 3,7-Dimethyl-3-octanol, Bernsteinsäuredimethylester, Benzyl-alkohol, DBE, Dodecan, Bernsteinsäurediethylester, Triglyme, Bicyclohexyl, Adipinsäuredimethylester, 1-Decanol oder 2-Pyrrolidon.

21. Verwendung von Lösungen gemäß einem oder mehreren der Ansprüche 1 bis 20 zur Erzeugung von Schichten der organischen Halbleiter auf einem Substrat.

22. Verfahren zur Herstellung organischer Halbleiterschichten auf einem Substrat, **dadurch gekennzeichnet, dass** eine Lösung gemäß einem oder mehreren der Ansprüche 1 bis 20 mittels eines Druckverfahrens verarbeitet wird.

23. Verfahren gemäß Anspruch 22, **dadurch gekennzeichnet, dass** es sich bei dem Druckverfahren um ein Tintenstrahl-Druckverfahren (IJP) handelt.

24. Verfahren zur Herstellung organischer Halbleiterschichten auf einem Substrat, **dadurch gekennzeichnet, dass** eine Lösung gemäß einem oder mehreren der Ansprüche 1 bis 20 mittels einem Flächenbeschichtungsverfahren verarbeitet wird.

25. Schichten organischer Halbleiter, **dadurch gekennzeichnet, dass** sie unter Verwendung einer Lösung gemäß einem oder mehreren der Ansprüche 1 bis 20 oder mittels eines Druckverfahrens gemäß Anspruch 22 und/oder 23 oder mittels eines Flächenbeschichtungsverfahrens gemäß Anspruch 24 erzeugt werden.

26. Organische oder polymere Leuchtdioden (OLED, PLED), organische Feld-Effekt-Transistoren (Ö-FET), organische Dünnfilmtransistoren (O-TFT), organische integrierte Schaltungen (O-IC), organische Solarzellen (O-SC) öder organische Laserdioden (O-Laser) enthaltend mindestens eine Schicht gemäß Anspruch 25.

## Claims

1. Single-phase, liquid compositions or solutions comprising
• at least one organic semiconductor which comprises at least one high-molecular-weight component,
• and at least one organic solvent A in which the semiconductor is soluble at a concentration of at least 5 g/l at room temperature and atmospheric pressure with formation of a clear, flowable solution,
• and at least one organic solvent B in which the semiconductor does not give a clear solution at a concentration of 5 g/l at room temperature and atmospheric pressure,
**characterised in that** the following applies to the boiling points (b.p.) of solvents A and B: b.p.(A) > b.p.(B).

2. Solutions according to Claim 1, **characterised in that** the organic semiconductor is soluble in pure solvent A at a concentration of at least 5 g/l at room temperature.

3. Solutions according to Claim 1 and/or 2, **characterised in that** the solubility of the organic semiconductor in pure solvent B at room temperature is less than 0.3 g/l.

4. Solutions according to one or more of Claims 1 to 3, **characterised in that** the organic semiconductor is employed as pure component.

5. Solutions according to one or more of Claims 1 to 3, **characterised in that** the organic semiconductor is a mixture of two or more components, at least one of which has semiconducting properties.

6. Solutions according to one or more of Claims 1 to 5, **characterised in that** the high-molecular-weight component has a molecular weight M_{w} of greater than 50,000 g/mol.

7. Solutions according to one or more of Claims 1 to 6, **characterised in that** the polymeric organic semiconductor is selected from the classes of the substituted poly-p-arylenevinylenes (PAVs), polyfluorenes (PFs), polyspirobifluorenes (PSFs), poly-para-phenylenes (PPPs) or -biphenylenes, polydihydrophenan-threnes (PDHPs), trans- and cis-polyindenofluorenes (PIFs), polyphenanthrenes, polythiophenes (PTs), polypyridines (PPys), polypyrroles, copolymers which have structural units from two or more of these classes, polyvinylcarbazoles (PVKs), triarylamine polymers and/or polymers having phosphorescent units, which are in each case soluble in organic solvents.

8. Solutions according to one or more of Claims 1 to 7, **characterised in that** nonconducting polymers (matrix polymers) which comprise admixed low-molecular-weight, oligomeric, dendritic, lightly to strongly branched and/or polymeric organic and/or organometallic semiconductors are used.

9. Solutions according to one or more of Claims 1 to 8, **characterised in that** they comprise between 0.01 and 20% by weight of the organic semiconductor.

10. Solutions according to one or more of Claims 1 to 9, **characterised in that** the boiling point of solvent A is above 110°C.

11. Solutions according to one or more of Claims 1 to 10, **characterised in that** the boiling point of solvent A is below 300°C.

12. Solutions according to one or more of Claims 1 to 11, **characterised in that** the boiling point of solvent B is above 50°C.

13. Solutions according to one or more of Claims 1 to 12, **characterised in that** the boiling point of solvent B is below 250°C.

14. Solutions according to one or more of Claims 1 to 13, **characterised in that** the difference of the boiling points between solvent A and solvent B is greater than 10 K.

15. Solutions according to one or more of Claims 1 to 14, **characterised in that** solvent A is used in a proportion of 70 to 99.8% by vol. and solvent B is used in a proportion of 0.2 to 30% by vol.

16. Solutions according to one or more of Claims 1 to 15, **characterised in that** further good and/or poor solvents are used in addition to solvents A and B.

17. Solutions according to one or more of Claims 1 to 16, **characterised in that**, as solvent A, use is made of mono- or polysubstituted aromatic solvents, formic acid derivatives, N-alkylpyrrolidones or high-boiling ethers.

18. Solutions according to Claim 17, **characterised in that**, as solvent A, one or more of the solvents are selected from 3-fluorobenzotrifluoride, benzotrifluoride, dioxane, trifluoromethoxybenzene, 4-fluorobenzotrifluoride, 3-fluoropyridine, toluene, 2-fluorotoluene, 2-fluorobenzotrifluoride, 3-fluorotoluene, pyridine, 4-fluorotoluene, 2,5-difluorotoluene, 1-chloro-2,4-difluorobenzene, 2-fluoropyridine, 3-chlorofluorobenzene, 1-chloro-2,5-difluorobenzene, 4-chlorofluorobenzene, chlorobenzene, 2-chlorofluorobenzene, p-xylene, m-xylene, o-xylene, 2,6-luti-dine, 2-fluoro-m-xylene, 3-fluoro-o-xylene, 2-chlorobenzotrifluoride, dimethylformamide, 2-chloro-6-fluorotoluene, 2-fluoroanisole, anisole, 2,3-dimethylpyrazine, bromobenzene, 4-fluoroanisole, 3-fluoroanisole, 3-trifluoromethylanisole, 2-methylanisole, phenetole, benzodioxole, 4-methylanisole, 3-methylanisole, 4-fluoro-3-methylanisole, 1,2-dichlorobenzene, 2-fluorobenzonitrile, 4-fluoro-veratrol, 2,6-dimethylanisole, aniline, 3-fluorobenzonitrile, 2,5-dimethylanisole, 2,4-dimethylanisole, benzonitrile, 3,5-dimethylanisole, N,N-dimethylaniline, 1-fluoro-3,5-dimethoxybenzene, phenyl acetate, N-methylaniline, methyl benzoate, N-methylpyrrolidone, 3,4-dimethylanisole, o-tolunitrile, veratrol, ethyl benzoate, N,N-diethylaniline, propyl benzoate, 1-methylnaphthalene, butyl benzoate, 2-methylbiphenyl, 2-phenylpyridine or 2,2'-bitolyl.

19. Solutions according to one or more of Claims 1 to 18, **characterised in that**, as solvent B, use is made of straight-chain, branched or cyclic alkanes, terpenes, (cyclo)aliphatic alcohols, ethers, ketones, carboxylic acid esters or mono- or polysubstituted aromatic solvents which are substituted by very long alkyl or alkoxy substituents.

20. Solutions according to Claim 19, **characterised in that**, as solvent B, one or more of the solvents are selected from tert-butyl methyl ether, acetone, methanol, hexane, ethyl acetate, ethanol, 2-butanone, cyclohexane, 2-propanol, tert-butanol, 1-propanol, 2-butanol, heptane, 2-pentanone, methylcyclohexane, 3-pentanone, 3-pentanol, 1-butanol, 1,4-dimethylcyclohexane, 1,3-dimethylcyclohexane, ethylene glycol monomethyl ether, 1,2-dimethylcyclohexane, octane, cyclopentanone, 2-hexanol, 1-pentanol, 1,2,4-trimethylcyclohexane, 4-heptanone, 3-heptanone, 2-heptanone, nonane, 3-heptanol, 1-hexanol, 2-heptanol, diglyme, butyl butyrate, tert-butylbenzene, decane, 1-heptanol, 2-octanol, butylcyclohexane, 2-ethyl-1-hexanol, decalin, propylene glycol, dimethyl sulfoxide, glycol, 3,7-dimethyl-1-octanol, 3,7-dimethyl-3-octanol, dimethyl succinate, benzyl alcohol, DBE, dodecane, diethyl succinate, triglyme, bicyclohexyl, dimethyl adipate, 1-decanol or 2-pyrrolidone.

21. Use of solutions according to one or more of Claims 1 to 20 for the production of layers of the organic semiconductors on a substrate.

22. Process for the production of organic semiconductor layers on a substrate, **characterised in that** a solution according to one or more of Claims 1 to 20 is processed by means of a printing process.

23. Process according to Claim 22, **characterised in that** the printing process is an ink-jet printing process (IJP).

24. Process for the production of organic semiconductor layers on a substrate, **characterised in that** a solution according to one or more of Claims 1 to 20 is processed by means of a surface-coating process.

25. Layers of organic semiconductors, **characterised in that** they are produced using a solution according to one or more of Claims 1 to 20 or by means of a printing process according to Claim 22 and/or 23 or by means of a surface-coating process according to Claim 24.

26. Organic or polymeric light-emitting diodes (OLEDs, PLEDs), organic field-effect transistors (O-FETs), organic thin-film transistors (O-TFTs), organic integrated circuits (O-ICs), organic solar cells (O-SCs) or organic laser diodes (O-lasers) comprising at least one layer according to Claim 25.

## Revendications

1. Compositions ou solutions liquides monophasiques, comprenant
• au moins un semi-conducteur organique qui comprend au moins un composant de haut poids moléculaire,
• et au moins un solvant organique A dans lequel le semi-conducteur est soluble selon une concentration d'au moins 5 g/l à température ambiante et pression atmosphérique avec la formation d'une solution limpide écoulable,
• et au moins un solvant organique B dans lequel le semi-conducteur ne donne pas de solution limpide selon une concentration de 5 g/l à température ambiante et pression atmosphérique,
**caractérisées en ce que** ce qui suit s'applique aux points d'ébullition (b.p.) des solvants A et B : b.p.(A) > b.p.(B).

2. Solutions selon la revendication 1, **caractérisées en ce que** le semi-conducteur organique est soluble dans le solvant pur A selon une concentration d'au moins 5 g/l à température ambiante.

3. Solutions selon la revendication 1 et/ou 2, **caractérisées en ce que** la solubilité du semi-conducteur organique dans le solvant pur B à température ambiante est inférieure à 0,3 g/l.

4. Solutions selon l'une ou plusieurs parmi les revendications 1 à 3, **caractérisées en ce que** le semi-conducteur organique est employé comme composant pur.

5. Solutions selon l'une ou plusieurs parmi les revendications 1 à 3, **caractérisées en ce que** le semi-conducteur organique est un mélange de deux, ou plus, composants, dont au moins un possède des propriétés de semi-conducteur.

6. Solutions selon l'une ou plusieurs parmi les revendications 1 à 5, **caractérisées en ce que** le composant de haut poids moléculaire possède un poids moléculaire M_{w} supérieur à 50 000 g/mol.

7. Solutions selon l'une ou plusieurs parmi les revendications 1 à 6, **caractérisées en ce que** le semi-conducteur organique polymère est choisi parmi les classes des poly-p-arylènevinylènes (PAV), polyfluorènes (PF), polyspirobifluorènes (PSF), poly-para-phénylènes (PPP) ou -biphénylènes, polydihydrophénanthrènes (PDHP), trans- et cis-polyindènofluorènes (PIF), polyphénanthrènes, polythio-phènes (PT), polypyridines (PPy), polypyrroles, substitués, des copolymères ayant des motifs structuraux issus de deux, ou plus, parmi ces classes, les polyvinylcarbazoles (PVK), les polymères de triarylamine et/ou les polymères ayant des motifs phosphorescents, qui sont dans chaque cas solubles dans des solvants organiques.

8. Solutions selon l'une ou plusieurs parmi les revendications 1 à 7, **caractérisées en ce qu'**on utilise des polymères non conducteurs (polymères de matrice) comprenant des semi-conducteurs organiques et/ou organométalliques polymères et/ou légèrement à fortement ramifiés, dendritiques, oligomères, de bas poids moléculaire, co-mélangés.

9. Solutions selon l'une ou plusieurs parmi les revendications 1 à 8, **caractérisées en ce qu'**elles comprennent entre 0,01 et 20% en poids du semi-conducteur organique.

10. Solutions selon l'une ou plusieurs parmi les revendications 1 à 9, **caractérisées en ce que** le point d'ébullition du solvant A est supérieur à 110°C.

11. Solutions selon l'une ou plusieurs parmi les revendications 1 à 10, **caractérisées en ce que** le point d'ébullition du solvant A est inférieur à 300°C.

12. Solutions selon l'une ou plusieurs parmi les revendications 1 à 11, **caractérisées en ce que** le point d'ébullition du solvant B est supérieur à 50°C.

13. Solutions selon l'une ou plusieurs parmi les revendications 1 à 12, **caractérisées en ce que** le point d'ébullition du solvant B est inférieur à 250°C.

14. Solutions selon l'une ou plusieurs parmi les revendications 1 à 13, **caractérisées en ce que** la différence des points d'ébullition entre le solvant A et le solvant B est supérieure à 10 K.

15. Solutions selon l'une ou plusieurs parmi les revendications 1 à 14, **caractérisées en ce que** le solvant A est utilisé selon une proportion allant de 70 à 99,8% en vol. et le solvant B est utilisé selon une proportion allant de 0,2 à 30% en vol.

16. Solutions selon l'une ou plusieurs parmi les revendications 1 à 15, **caractérisées en ce que** des solvants bons et/ou médiocres supplémentaires sont utilisés en plus des solvants A et B.

17. Solutions selon l'une ou plusieurs parmi les revendications 1 à 16, **caractérisées en ce que**, comme solvant A, on utilise des solvants aromatiques mono- ou poly-substitués, des dérivés d'acide formique, des N-alkylpyrrolidones ou des éthers à point d'ébullition élevé.

18. Solutions selon la revendication 17, **caractérisées en ce que**, comme solvant A, un ou plusieurs parmi les solvants sont choisis parmi le 3-fluorobenzotrifluorure, le benzotrifluorure, le dioxane, le trifluorométhoxybenzène, le 4-fluorobenzotrifluorure, la 3-fluoropyridine, le toluène, le 2-fluorotoluène, le 2-fluorobenzotrifluorure, le 3-fluorotoluène, la pyridine, le 4-fluorotoluène, le 2,5-difluoro-toluène, le 1-chloro-2,4-difluorobenzène, la 2-fluoropyridine, le 3-chlorofluorobenzène, le 1-chloro-2,5-difluorobenzène, le 4-chlorofluorobenzène, le chloro-benzène, le 2-chlorofluorobenzène, le p-xylène, le m-xylène, l'o-xylène, la 2,6-lutidine, le 2-fluoro-m-xylène, le 3-fluoro-o-xylène, le 2-chlorobenzotrifluorure, le diméthylformamide, le 2-chloro-6-fluorotoluène, le 2-fluoroanisole, l'anisole, la 2,3-diméthylpyrazine, le bromobenzène, le 4-fluoroanisole, le 3-fluoroanisole, le 3-trifluorométhylanisole, le 2-méthylanisole, le phénétole, le benzodioxole, le 4-méthylanisole, le 3-méthylanisole, le 4-fluoro-3-méthylanisole, le 1,2-dichloro-benzène, le 2-fluorobenzonitrile, le 4-fluorovératrol, le 2,6-diméthylanisole, l'aniline, le 3-fluorobenzonitrile, le 2,5-diméthylanisole, le 2,4-diméthylanisole, le benzonitrile, le 3,5-diméthylanisole, la N,N-diméthylaniline, le 1-fluoro-3,5-diméthoxybenzène, l'acétate de phényle, la N-méthylaniline, le benzoate de méthyle, la N-méthylpyrrolidone, le 3,4-diméthylanisole, l'o-toluonitrile, le vératrol, le benzoate d'éthyle, la N,N-diéthylaniline, le benzoate de propyle, le 1-méthyl-naphtalène, le benzoate de butyle, le 2-méthylbiphényle, la 2-phénylpyridine ou le 2,2'-bitolyle.

19. Solutions selon l'une ou plusieurs parmi les revendications 1 à 18, **caractérisées en ce que**, comme solvant B, on utilise des alcanes à chaîne linéaire, ramifiée ou cyclique, des terpènes, des alcools (cyclo)aliphatiques, des éthers, des cétones, des esters d'acide carboxylique ou des solvants aromatiques mono- ou poly-substitués qui sont substitués par de très longs substituants alkyle ou alcoxy.

20. Solutions selon la revendication 19, **caractérisées en ce que**, comme solvant B, un ou plusieurs parmi les solvants sont choisis parmi le tertio-butyl-méthyléther, l'acétone, le méthanol, l'hexane, l'acétate d'éthyle, l'éthanol, la 2-butanone, le cyclohexane, le 2-propanol, le tertio-butanol, le 1-propanol, le 2-butanol, l'heptane, la 2-pentanone, le méthylcyclohexane, la 3-pentanone, le 3-pentanol, le 1-butanol, le 1,4-diméthylcyclohexane, le 1,3-diméthylcyclohexane, l'éthylène glycol monométhyléther, le 1,2-diméthylcyclohexane, l'octane, la cyclopentanone, le 2-hexanol, le 1-pentanol, le 1,2,4-triméthylcyclohexane, la 4-heptanone, la 3-heptanone, la 2-heptanone, le nonane, le 3-heptanol, le 1-hexanol, le 2-heptanol, le diglyme, le butyrate de butyle, le tertio-butylbenzène, le décane, le 1-heptanol, le 2-octanol, le butylcyclohexane, le 2-éthyl-1-hexanol, la décaline, le propylène glycol, le diméthylsulfoxyde, le glycol, le 3,7-diméthyl-1-octanol, le 3,7-diméthyl-3-octanol, le succinate de diméthyle, l'alcool benzylique, le DBE, le dodécane, le succinate de diéthyle, le triglyme, le bicyclohexyle, l'adipate de diméthyle, le 1-décanol ou la 2-pyrrolidone.

21. Utilisation de solutions selon l'une ou plusieurs parmi les revendications 1 à 20 pour la production de couches des semi-conducteurs organiques sur un substrat.

22. Procédé de production de couches de semi-conducteur organique sur un substrat, **caractérisé en ce qu'**une solution selon l'une ou plusieurs parmi les revendications 1 à 20 est traitée par un procédé d'impression.

23. Procédé selon la revendication 22, **caractérisé en ce que** le procédé d'impression est un procédé d'impression par jet d'encre (IJP).

24. Procédé de production de couches de semi-conducteur organique sur un substrat, **caractérisé en ce qu'**une solution selon l'une ou plusieurs parmi les revendications 1 à 20 est traitée au moyen d'un procédé de revêtement de surface.

25. Couches de semi-conducteurs organiques, **caractérisées en ce qu'**elles sont produites en utilisant une solution selon l'une ou plusieurs parmi les revendications 1 à 20 ou au moyen d'un procédé d'impression selon la revendication 22 et/ou 23 ou au moyen d'un procédé de revêtement de surface selon la revendication 24.

26. Diodes organiques ou polymères émettrices de lumière (OLED, PLED), transistors organiques à effet de champ (O-FET), transistors organiques à film fin (O-TFT), circuits intégrés organiques (O-IC), cellules solaires organiques (O-SC) ou diodes laser organiques (O-lasers) comprenant au moins une couche selon la revendication 25.
